# EUROPÄISCHE PATENTANMELDUNG

(11) **EP 1 837 907 A2**
(43) Veröffentlichungstag der Anmeldung: **26.09.2007**
(21) Anmeldenummer: 07005340.0
(22) Anmeldetag: 15.03.2007
(51) Int. Cl.: H01L 23/29

(54) **Leistungshalbleiterbauelement mit Passivierungsschicht und zugehöriges Herstellungsverfahren**

(30) Priorität: 22.03.2006 DE 102006013076
(71) Anmelder: SEMIKRON Elektronik GmbH & Co. KG, 90431 Nürnberg (DE)
(72) Erfinder: Simic, Dejan, 90579 Langenzenn (DE); König, Bernhard, Dr., 90765 Fürth (DE)

(57) **Zusammenfassung**

Die Erfindung beschreibt ein Leistungshalbleiterbauelement und ein zugehöriges Verfahren zu dessen Herstellung mit den Verfahrensschritten:
• Durchführung aller Epitaxie- und/oder Diffusions- und Strukturierungsprozessen des Halbleiterkörpers;
• Passivierung mittels eines Siebdruckverfahrens mit einem siebdruckfähigen Stoff;
• Vereinzelung der Leistungshalbleiterbauelemente;

und Metallisierung mindestens einer Teilfläche einer Hauptfläche vor oder nach dem Passivierungsschritt.

## Beschreibung

Die Erfindung beschreibt ein Leistungshalbleiterbauelement mit mindestens einem pn- Übergang und einer Passivierungsschicht ebenso wie ein zugehöriges Herstellungsverfahren. Einen Ausgangspunkt der Erfindung bilden Leistungshalbleiterbauelemente wie sie beispielhaft aus der DE 40 13 435 A1 bekannt sind. Dort ist einerseits die Funktion von Passivierungsschichten und anderseits der Aufbau von Leistungshalbleiterbauelementen mit MESA Struktur ausführlich dargestellt.

Aus dieser Druckschrift sind Leistungshalbleiterbauelemente bekannt, die als Primärpassivierungsschicht beispielhaft Schichten aus amorphem Silizium, amorphem Siliziumcarbid oder auch amorphem wasserstoffhaltigen Kohlenstoff aufweisen. Bekannt ist weiterhin, dass derartige Primärpassivierungsschichten für Leistungshalbleiterbauelement in MESA wie auch in planarer Struktur aus einer Schichtfolge beispielhaft lithographisch strukturierte Schichten aufgebaut sind. Dies kann beispielhaft eine Schichtfolge aus Siliziumoxid, Polysilizium und einer weiteren Schicht aus Siliziumnitrit sein. Derartige Schichten oder Schichtfolgen, die die Primärpassivierungsschicht bilden, werden mittels aus der Herstellung von Halbleiterbauelementen bekannten Technologien hergestellt und strukturiert.

Gemäß dem Stand der Technik werden derartige Primärpassivierungsschichten häufig mittels einer Sekundärpassivierungsschicht beispielhaft mit einem sog. Photoimid abgedeckt, um diese besonders gegen mechanische und chemische Einflüsse zu schützen. Dieser Schutz ist beispielhaft notwendig bei der löttechnischen Verbindung des Leistungshalbleiterbauelements mit einem Substrat oder auch beim Einsatz von mittels dieser Leistungshalbleiterbauelemente aufgebauter Leistungshalbleitermodule in industriellen Umgebungen. Unter Photoimid wird hier ein Polyimid verstanden, das mittels eines Aufschleuderprozesses auf Leistungshalbleiterbauelemente im Waferverbund aufgetragen wird, anschließend strukturiert und teilweise chemisch, vorzugsweise nasschemisch, wieder entfernt und in einem weiteren Schritt polymerisiert wird.

Beispielhaft aus der DE 44 10 354 A1 ist eine Passivierungsschicht aus Glas, vorzugsweise Bleiglas, bekannt, die auf die Oberfläche eines Leistungshalbleiterbauelements mit planarer Struktur aufgeschleudert, anschließend gesintert und strukturiert wird. Primärpassivierungsschichten aus Glas werden in der Regel nicht durch eine weitere Sekundärpassivierungsschicht abgedeckt, da diese eine ausreichende Widerstandsfähigkeit gegen die meisten Umgebungsbedingungen aufweisen.

Der Erfindung liegt die Aufgabe zugrunde ein Leistungshalbleiterbauelement sowie ein zugehöriges Herstellungsverfahren vorzustellen wobei mittels einer einfach herzustellender und kostengünstigen Passivierungsschicht die entsprechenden Teilfläche abgedeckt werden, wobei diese Passivierungsschicht das Leistungshalbleiterbauelement gegen mechanische und chemische Einflüsse schützt.

Die Aufgabe wird erfindungsgemäß gelöst, durch die Maßnahmen der Merkmale der Ansprüche 1 und 5. Bevorzugte Ausführungsformen sind in den Unteransprüchen beschrieben.

Der erfinderische Gedanke geht aus von einem Leistungshalbleiterbauelement bestehend aus einem Halbleiterkörper, wobei dessen Grundkörper eine erste Leitfähigkeit aufweist. Der Halbleiterkörper weist weiterhin mindestens einen Teilkörper bzw. Bereiche mit einer zweiten Leitfähigkeit auf. Hierdurch wird mindestens ein pn- Übergang des Leistungshalbleiterbauelements ausgebildet. Grundsätzlich sind für die Halbleiterkörper derartiger Leistungshalbleiterbauelemente zwei Strukturvarianten bekannt. Eine erste Ausgestaltung ist als sog. MESA Strukturen bekannt während eine zweite Ausgestaltung mittels sog. planarer Strukturen ausgebildet ist. Die Erfindung bezieht sich auf beide bekannte Strukturen.

Leistungshalbleiterbauelemente der genannten Ausgestaltungen sind beispielhaft Dioden, Thyristoren oder Transistoren. Die Bereiche unterschiedlicher Leitfähigkeit der Teilkörper bzw. Bereiche des Halbleiterkörpers derartiger Leistungshalbleiterbauelemente werden durch eine geeignet Kombination von Epitaxie-, Diffusions- und Strukturierungsprozessen gebildet. Weiterhin notwendig zur Ausbildung des Leistungshalbleiterbauelements sind.Metallisierungsprozesse für Kontaktflächen.

Dem Stand der Technik entsprechend weisen derartige Leistungshalbleiterbauelemente mindestens eine Teilfläche mindestens einer Hauptfläche auf, die von einer Passivierungsschicht überdeckt sein muss. Vorzugsweise werden hierbei Teilflächen abgedeckt an denen der pn- Übergang eine Außenfläche des Halbleiterkörpers erreicht.

Erfindungsgemäß ist die mindestens eine Passivierungsschicht ausgebildet als eine Schicht aus einem siebdruckfähigen Stoff, wie beispielhaft einem Polyimid. Die Reihenfolge der Prozessschritte Passivierung und Metallisierung ist für die Wirksamkeit der Erfindung nicht maßgeblich.

Alle vorgenannten Verarbeitungsschritte finden vorzugsweise im Waferverbund vor der Vereinzelung in einzelne Leistungshalbleiterbauelemente statt.

Es ist bevorzugt an den Prozessschritt des Siebdruckens einen Ausheizprozess des siebdruckfähigen Stoffes anzuschließen und im Weiteren die Leistungshalbleiterbauelemente zu vereinzeln.

Die erfinderische Lösung wird an Hand der Ausführungsbeispiele der Fig. 1 bis 3 weiter erläutert.

Fig. 1 zeigt ein erstes erfindungsgemäßes Leistungshalbleiterbauelement mit planarer Struktur.

Fig. 2 zeigt ein zweites erfindungsgemäßes Leistungshalbleiterbauelement mit planarer Struktur.

Fig. 3 zeigt ein erfindungsgemäßes Leistungshalbleiterbauelement mit MESA Struktur.

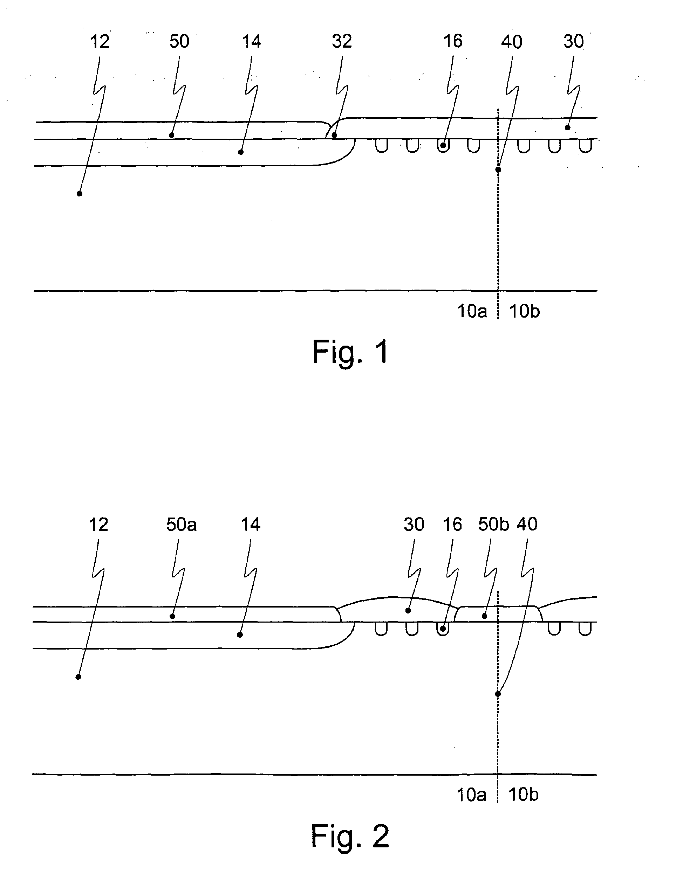

Fig. 1 zeigt schematisch ein erstes erfindungsgemäßes Leistungshalbleiterbauelement (10) mit planarer Struktur im Waferverbund. Dargestellt ist jeweils der Randbereich eines ersten (10a) und ein zweiten Leistungshalbleiterbauelements (10b) sowie die Linie (40) entlang derer nach allen Herstellungsschritten die Vereinzelung erfolgt. Der Halbleiterkörper des jeweiligen Leistungshalbleiterbauelements (10) weist einen Grundkörper erster Leitfähigkeit (12) sowie ein Diffusionsgebiet zweiter Leitfähigkeit (14) auf, wodurch ein pn- Übergang ausgebildet wird. Alternativ oder zusätzlich kann das Leistungshalbleiterbauelement (10) auch mittels Epitaxieverfahren hergestellte Gebiete aufweisen ohne dass hierdurch die Erfindung eingeschränkt wäre.

Als weitere Strukturen sind noch Potentialringe (16) zweiter Leitfähigkeit im Randbereich des Leistungshalbleiterbauelements (10) angedeutet. Diese Potentialringe (16) und der Bereich in dem der pn- Übergang die erste Hauptfläche des Leistungshalbleiterbauelements (10) erreicht sind erfindungsgemäß mit einer Passivierungsschicht (30) bedeckt. Diese Passivierungsschicht (30) besteht aus einem siebdruckfähigen Stoff, hier einem Polyimid.

Es ist besonders bevorzugt, wenn dieses Polyimid eine Schichtdicke von mindestens 7µm, eine dynamische Viskosität von mindestens 32000cps, sowie einen Thixotropieindex von 2 bis 5 aufweist. Die Temperaturbeständigkeit des Polyimids sollte bevorzugt mindestens 440°C betragen. Für den Siebdruck des Polyimids ist eine Maschengröße des Drucksiebs von 200 bis 325mesh besonders bevorzugt.

Die erfindungsgemäße Passivierungsschicht (30) aus siebgedrucktem Polyimid wird in ihrem Randbereich (32) von einer Metallisierung (50), die als elektrische Kontaktfläche des Leistungshalbleiterbauelements dient, teilweise überdeckt.

Fig. 2 zeigt schematisch ein zweites erfindungsgemäßes Leistungshalbleiterbauelement (10) mit planarer Struktur im Waferverbund. Der Halbleiterköper ist gleichartig demjenigen in Fig. 1 ausgebildet.

Eine erste Teilmetallisierung (50a) überdeckt den Bereich zweiter Leitfähigkeit (14) und bildet die elektrische Kontaktschicht des Leistungshalbleiterbauelements. Eine zweite Teilmetallisierung (50b), die vorzugsweise identisch der ersten ausgebildet ist überdeckt den Bereich in dem die Vereinzelung durchführt wird. Beide Teilmetallisierungen (50 a/b) werden in ihrem Randbereich teilweise durch das siebgedruckte Polyimid (30) als Passivierungsschicht überdeckt. Durch einen an den Siebdruckprozess anschließenden Polymerisierungsprozess mittels Erhitzen auf über 300°C bildet das Polyimid eine konvexe Oberfläche aus.

Als Alternative zum genannten Polyimid können auch andere siebdruckfähige organische Stoffe, wie Lacke oder Kautschukverbindungen als Passivierungsschicht im Siebdruckverfahren aufgebracht werden.

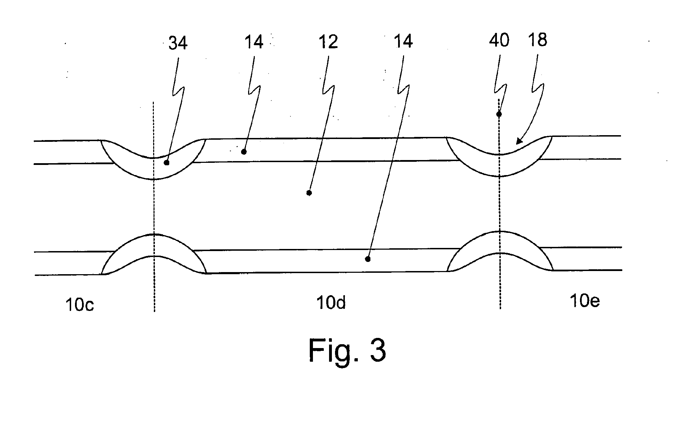

Fig. 3 zeigt schematisch die Halbleiterköper erfindungsgemäßer Leistungshalbleiterbauelemente (10 c/d/e) mit MESA Struktur im Waferverbund. Dargestellt ist der Grundkörper erster Leitfähigkeit (12) sowie zwei Diffusionsgebiete zweiter Leitfähigkeit (14). Diese Ausgestaltung entspricht der grundlegenden, nicht vollständigen, Ausgestaltung eines Leistungsthyristors.

Die Passivierungsschicht (34) ist hier als Bleiglasschicht ausgebildet, die als Suspension mittels des erfindungsgemäßen Siebdruckverfahrens in den Gräben (18) des Halbleiterkörpers angeordnet wurde. Hierbei füllt die Bleiglassuspension den jeweiligen Graben (18) fast vollständig auf. In einem weiteren Prozessschritt wird die Suspension verglast. Die anschließend Vereinzelung derartiger Leistungshalbleiterbauelemente (10 c/d/e) erfolgt wiederum entlang der Linie (40).

Es ist besonders bevorzugt, wenn das Bleiglas bei Leistungshalbleiterbauelement in MESA Struktur eine Schichtdicke über dem pn- Übergang von mindestens 20µm beträgt. Besonders bevorzugt ist es wenn als Passivierungsschicht ein Glas mit einer Sintertemperatur von weniger als 500°C verwendet wird.

## Patentansprüche

1. Leistungshalbleiterbauelement (10) mit einem Halbleiterkörper mit mindestens einem pn- Übergang und mindestens einer auf einer Teilfläche einer Hauptfläche angeordneten Passivierungsschicht (30, 34),
wobei diese Passivierungsschicht (30, 34) als eine Schicht aus siebdruckfähigem Stoff (30, 34) ausgebildet ist.

2. Leistungshalbleiterbauelement (10) nach Anspruch 1
wobei das Leistungshalbleiterbauelement (10) in MESA- Struktur oder in planarer Struktur ausgebildet ist.

3. Leistungshalbleiterbauelement (10) nach Anspruch 1
wobei der siebdruckfähige Stoff als ein organischer Stoff, wie ein Polyimid, ein Lack oder ein Kautschuk ausgebildet ist.

4. Leistungshalbleiterbauelement (10) nach Anspruch 1
wobei der siebdruckfähige Stoff als ein anorganisches, glasartiges Material ausgebildet ist.

5. Verfahren zur Herstellungen eines Leistungshalbleiterbauelements (10) nach einem der vorgenannten Ansprüche,
**gekennzeichnet durch** die Verfahrensschritte:
• Durchführung aller Epitaxie- und/oder Diffusions- und Strukturierungsprozessen des Halbleiterkörpers;
• Passivierung mittels eines Siebdruckverfahrens mit einem siebdruckfähigen Stoff (30, 32, 34);
• Vereinzelung der Leistungshalbleiterbauelemente (10);
und Metallisierung mindestens einer Teilfläche einer Hauptfläche vor oder nach dem Passivierungsschritt.

6. Verfahren nach Anspruch 5,
wobei der siebdruckfähige Stoff (30) als ein Polyimid ausgebildet ist, das eine Schichtdicke von mindestens 7µm, eine Temperaturbeständigkeit bis mindestens 440°C, eine dynamische Viskosität von mindestens 32000cps, und eine Thixotropieindex von mindestens 2 aufweist.

7. Verfahren nach Anspruch 5,
wobei der siebdruckfähige Stoff (30) als eine Bleiglassuspension ausgebildet ist, das eine Schichtdicke von mindestens 20µm und eine Sintertemperatur von weniger als 500°C aufweist.

8. Verfahren nach Anspruch 5,
wobei sich an den Prozessschritt des Siebdruckens ein Ausheizprozess des siebdruckfähigen Stoffes (30, 32, 34) anschließt.

9. Verfahren nach Anspruch 5,
wobei mittels dieses Siebdruckverfahrens Gräben (18) von im Waferverbund angeordneten Leistungshalbleiterbauelemente (10) in MESA Struktur zumindest teilweise mit dem siebdruckfähigen Stoff (34) verfüllt werden.

10. Verfahren nach Anspruch 5,
wobei das Sieb eine Maschengröße von 200 bis 325mesh aufweist.
